Europäisches Patentamt

European Patent Office

Office européen des brevets

(11) Publication number: **0 253 014**
B1

## EUROPEAN PATENT SPECIFICATION

(45) Date of publication of the patent specification:
**11.04.90**

(51) Int. Cl.⁴: **H01L 29/78**
// G11C17/00

(21) Application number: **86109876.2**

(22) Date of filing: **18.07.86**

(54) Method of manufacturing a monvolatile semiconductor memory apparatus with writing and erasing capability.

(43) Date of publication of application:
**20.01.88 Bulletin 88/3**

(45) Publication of the grant of the patent:
**11.04.90 Bulletin 90/15**

(84) Designated Contracting States:
**DE FR GB**

(56) References cited:
**EP-A- 0 160 965
GB-A- 2 130 009
US-A- 4 099 196
US-A- 4 274 012**

**IBM TECHNICAL DISCLOSURE BULLETIN, vol. 20,
no. 11B, April 1978, page 4961, IBM Corp., New York, US;
E.A. IRENE: "Method to avoid the polysilicon film
tearing mechanism"**

(73) Proprietor: **NIPPONDENSO CO., LTD., 1-1, Showa-cho,
Kariya-shi Aichi-ken(JP)**

(72) Inventor: **Fujii, Tetsuo, 129 Shinhonmachi, Toyohashi-shi
Aichi-ken(JP)**
Inventor: **Sakakibara, Toshio, 2-1, Higashigomawari
Kaifuku-cho, Nishio-shi Aichi-ken(JP)**
Inventor: **Sakakibara, Nobuyoshi, 3-43, Nakago-cho,
Hekinan-shi Aichi-ken(JP)**

(74) Representative: **Kuhnen, Wacker & Partner,
Schneggstrasse 3-5 Postfach 1553, D-8050 Freising(DE)**

## Description

The present invention relates to a method of manufacturing a nonvolatile semiconductor memory apparatus in which a tunnel current flows through an insulating film comprising a relatively thick (400 to 2 000 angstroms) oxide film and charges are injected into a floating gate to write or erase data utilizing a phenomenon wherein an electric field tends to be concentrated on a roughened portion formed on the surface of a polycrystalline silicon (polysilicon) film, and more particularly the present invention relates to the method of claim 1.

In the manufacture of a nonvolatile memory apparatus, when a polysilicon film to be used as a floating gate or a writing gate is formed, a roughened portion is formed on the surface of the polysilicon film. This is done to prepare a nonvolatile memory, i.e, an EEPROM. In such a memory, a predetermined voltage is applied to the polysilicon film portion to cause an electric field concentration phenomenon on the portion, and even when a relatively thick (e.g. 80.0 nm) oxide film is formed as an electron discharge source, a tunnel current is flowed through the oxide film to electrically control erase and write operations.

However, in order to control the shape of the roughened portion on the surface of the polysilicon film, deposition conditions e.g., a deposition temperature, a deposition rate, and the like) must be optimally set during a polysilicon deposition step. In addition, when oxidation conditions (e.g., an oxidation temperature, an oxidation atmosphere, and the like) are set during an oxidation step following the deposition step, a strict control operation is necessary. Therefore, when the roughened portion is formed on the surface of the polysilicon film, it is difficult to control its shape, and the resultant roughened shape often does not correspond to the target shape, thus impairing the reliability of the semiconductor memory apparatus.

US-A 4 274 012 and US-A 4 099 196 disclose a polysilicone film acting as the injecting gate and the floating gate whose upper surface is rough.

It is an object of the present invention to provide a method of manufacturing a nonvolatile semiconductor memory apparatus in which charges are injected into a floating gate upon use of electric field concentration on a roughened portion formed on the surface of a polysilicon film.

It is another object of the present invention to provide a method of manufacturing a highly reliable, nonvolatile semiconductor memory apparatus in which a roughened portion for concentrating an electric field thereon can be formed during a deposition step of a polysilicon film, without intentionally forming it on the surface of the polysilicon film.

It is still another object of the present invention to provide a method of manufacturing a semiconductor memory apparatus which can effectively use a roughened portion on the surface of a polysilicon film after the deposition step thereof.

These objects are obtained by the method of claim 1. Preferred embodiments of the invention are claimed in the subclaims 2 to 11.

With the nonvolatile semiconductor memory apparatus obtainable according to the present invention, a roughened portion is not intentionally formed on the polysilicon film after the surface of the polysilicon film is oxidized, but a roughened portion formed immediately after the deposition step of the polysilicon film is utilized. The shape of this roughened portion is determined only by deposition conditions of the polysilicon film, and can be relatively easily controlled with high precision. When the thus deposited polysilicon film is thermally oxidized at a temperature higher than the predetermined temperature, the shape of the roughened portion formed on the surface of the polysilicon film can be duplicated by a film thermally oxidized formed during a thermal oxidation step. The present inventors found that the surface of the polysilicon film is recrystallized to be substantially flattened, thus preventing an electric field concentration phenomenon on this portion.

A new polysilicon film is formed on the surface of the thermal oxide film on which the roughened portion is formed. The surface portion of the new polysilicon film, which is in contact with the thermal oxide film, duplicates the roughened shape of the surface of the thermal oxide film. In this way, the roughened portion for concentrating the electric field can be formed on the surface of the new polysilicon film.

More specifically, the roughened portion formed during the deposition step of the first polysilicon film can be duplicated by the new polysilicon film. Therefore, it is easy to obtain a structure which can easily concentrate an electric field only on the roughened portion of the new polysilicon film, so that unidirectional electrons or charges easily flow.

This invention can be more fully understood from the following detailed description when taken in conjunction with the accompanying drawings, in which:

Fig. 1 is a sectional view of one memory section of a nonvolatile semiconductor memory apparatus according to an embodiment of the present invention;

Fig. 2 is a sectional view taken along line II - II in Fig. 1;

Figs. 3 and 4 are sectional views for respectively explaining the write and erase operations in the semiconductor memory apparatus shown in Fig. 1;

Figs. 5A to 5D are sectional views for sequentially explaining the steps in the manufacture of the semiconductor memory apparatus shown in Fig. 1;

Fig. 6 is a graph showing conditions for flattening the surface of a polysilicon film after thermal oxidation in the manufacture of the semiconductor memory apparatus;

Fig. 7 is a graph showing the relationship between oxidation temperature T and effective barrier height in relation to a given phosphorus concentration in a specific polysilicon film;

Figs. 8A and 8B are diagrams for explaining electron injection conditions corresponding to characteristics A and B shown in Fig. 7; and

Figs. 9A to 9C are photographs showing the roughened surface state of the polysilicon film in the manufacture of the semiconductor memory apparatus obtainable according to the present invention.

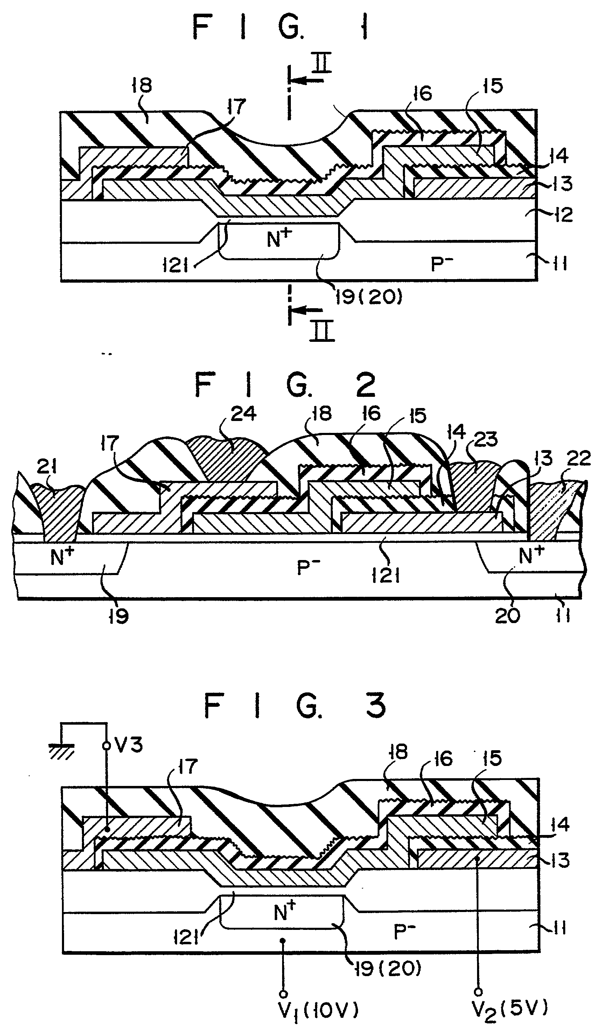

A nonvolatile semiconductor memory apparatus obtainable according to the present invention comprises, e.g., an EPROM or an EEPROM. In this embodiment, the EEPROM will be exemplified. Figs. 1 and 2 show a memory cell portion of the EEPROM, and exemplify a structure where a write gate for the memory cell is formed on a semiconductor substrate. Of course, the present invention can be applied to a semiconductor apparatus of a structure which uses a breakdown phenomenon inside the semiconductor substrate or channel hot electrons as a write means.

In this memory apparatus, semiconductor substrate 11 comprises a p–type silicon substrate having a resistivity of 5 to 20 $\Omega \cdot$ cm and orientation of (100). 1.0 $\mu$m thick field oxide film 12 is formed on the surface of substrate 11 using a selective oxidation technique. First polysilicon film 13 serving as an erase gate is formed on the surface portion of field oxide film 12, and first thermal oxide film 14 is formed on film 13. Second polysilicon film 15 serving as a floating gate is deposited on a portion of film 14 and on film 13.

Second thermal oxide film 16 is formed on the surface of film 15, and third polysilicon film 17 serving as an electron injection gate is selectively formed on a portion of film 16 and on film 12. Reference numeral 18 denotes an insulating protective film of silicon oxide ($SiO_2$) formed by the CVD method.

In field oxide film 12, portion 121 corresponding to $n^+$-type source region 19 and drain region 20 of a MOS transistor formed on semiconductor substrate 11 is formed to be thin. Contact electrodes 21 and 22 are formed on the surface portions of substrate 11 to correspond to source and drain regions 19 and 20. In addition, erase electrode 23 is formed to correspond to first polysilicon film 13, and charge injection gate electrode 24 is formed to correspond to third polysilicon film 17. Note that in Figs. 1 and 2, metal wiring layers are omitted.

The surfaces of first and second thermal oxide films 14 and 16 are roughened, as shown in Figs. 1 and 2. The roughened portions are formed by duplicating the roughened portions formed on the surfaces of polysilicon films 13 and 15 when they are deposited. In this way, since second and third polysilicon films 15 and 17 are formed on first and second thermal oxide films 14 and 16 having the roughened portions, respectively, roughened portions corresponding to those formed on oxide films 14 and 16 are respectively formed on the back surface portions of films 15 and 17.

During write and erase operations performed by injecting electrons to second polysilicon film 15 serving as the floating gate, sufficient electric field concentration occurs on the roughened surface portions formed on the back surface portions of films 17 and 15. Therefore, even if a relatively thick oxide film is formed, the write and erase operations are enabled.

In contrast to this, the surface portions of films 13 and 15 are substantially flattened. For this reason, almost no electric field concentration occurs on the surface portions of films 13 and 15, and electrons flowing in a reverse direction.

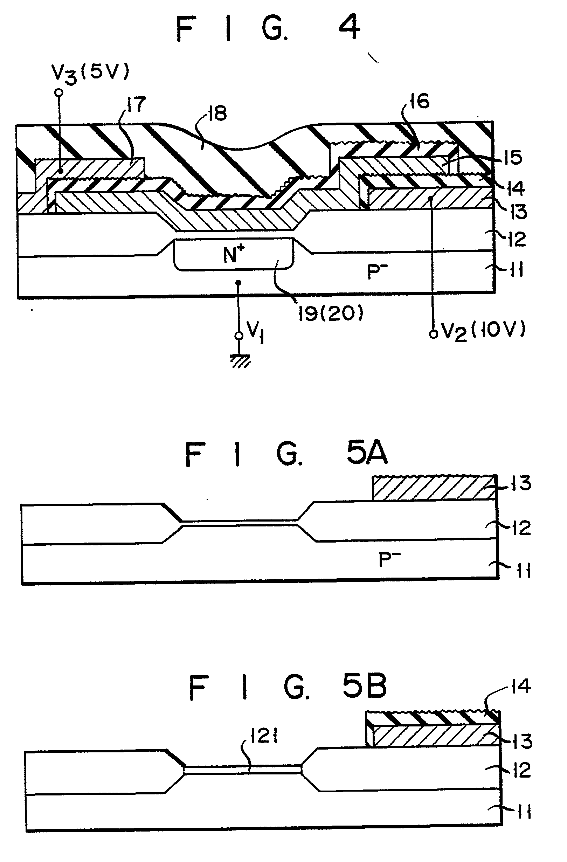

Fig. 3 shows a write operation state of the EEPROM. In the write mode shown in Fig. 3, third polysilicon film 17 serving as the electron injection gate is connected to a ground potential (V3 = 0), and semiconductor substrate 11 is connected to a high potential (e.g., V1 = 10 V). First polysilicon film 13 serving as the erase gate is connected to a medium potential (e.g., V2 = 5 V). More specifically, the relation V1 < V2 < V3 is obtained, and the electric field is concentrated on the roughened portions of third polysilicon film 17, so that electrons are injected to the second polysilicon film 15 side serving as the floating gate, thus allowing the charge write operation.

Fig. 4 shows an erase operation state of the EEPROM. In the erase mode, third polysilicon film 17 is connected to a medium potential (e.g., V3 = 5 V), and semiconductor substrate 11 is connected to a ground potential (V1 = 0). In addition, first polysilicon film 13 is connected to a high potential (e.g., V2 = 10 V). Thus, the relation V2 < V3 < V1 is obtained, so that the electric field is concentrated on the roughened portions of second polysilicon film 15. In this state, electrons flow to the first polysilicon film 13 side, and the charges held therein are erased.

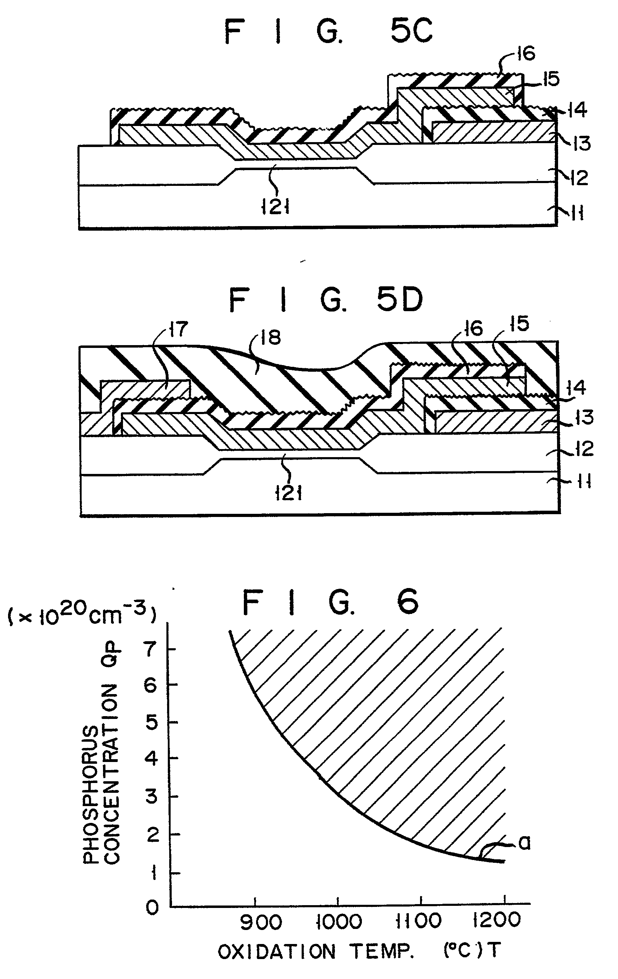

The method of manufacturing this nonvolatile semiconductor memory apparatus will now be described. First, as shown in Fig. 5A, 1.0 $\mu$m thick field oxide film 12 is formed on the surface of $p^-$-type silicon substrate 11 using a selective oxidation technique. Then, a polysilicon film is deposited by the LPCVD method on the entire surface of substrate 11, not at high temperature but in an atmosphere at a temperature of 550 to 650°C (in this embodiment, 610°C) under the flow of silane ($SiH_4$) gas and phosphine ($PH_3$) gas. This is to prevent crystal particles in the deposited polysilicon film from being recrystallized and grown during the deposition. In addition, this is to maintain the roughened portions formed on the surface of the polysilicon film during the deposition as much as possible.

The deposited polysilicon film is selectively etched using a predetermined pattern to form first polysilicon film 13.

Note that the phosphorus concentration in polysilicon film 13 is $1 \times 10^{20}$ to $7 \times 10^{20}$ cm$^{-3}$, and is preferably $3 \times 10^{20}$ to $6 \times 10^{20}$ cm$^{-3}$ taking the oxidation temperature into consideration (Fig. 6). The shape of the roughened portions film can be accurately determined under the above-mentioned temperature control.

After first polysilicon film 13 is formed, the thin portion of oxide film 12 except for the field portion is removed by etching to locally expose the surface of substrate 11. Then, oxidation is performed in an atmosphere of dry $O_2$ gas or the same containing HCl at a temperature of 900 to 1,300°C and, preferably, 1,000 to 1,200°C, so that new oxide film 121 of a thickness of 40,0 to 150,0 $\mu$m is formed as shown in Fig. 5B. In this case, oxidation can be performed by a heating means (e.g., a halogen lamp) using a quick oxidation technique for ten seconds to several minutes within a temperature range of 1,150 to 1,300°C.

In this way, first thermal oxide film 14 is formed on the surface of first polysilicon film 13. First thermal oxide film 14 duplicates the surface state (roughened state) formed when polysilicon for film 13 is deposited. The roughened portion is formed on the surface of thermal oxide film 14. However, it was found that the surface of polysilicon film 13 is virtually flattened since re-crystallization of polysilicon occurs during the thermal oxidation to increase the crystal particle size.

From the test results of the present inventors, as shown in Fig. 6, the surface flattening phenomenon of first polysilicon film 13 was observed in a hatched region above the boundary indicated by characteristic curve a, using phosphorus concentration Qp and oxidation temperature T as parameters.

Conditions for causing the surface flattening phenomenon were found to be as follows. The phosphorus concentration in the polysilicon film must fall within the range of $1 \times 10^{20}$ to $7 \times 10^{20}$ cm$^{-3}$ and, preferably, $3 \times 10^{20}$ to $6 \times 10^{20}$ cm$^{-3}$, and the oxidation temperature must fall within the range of 900 to 1,300°C and, preferably 1,000 to 1,200°C.

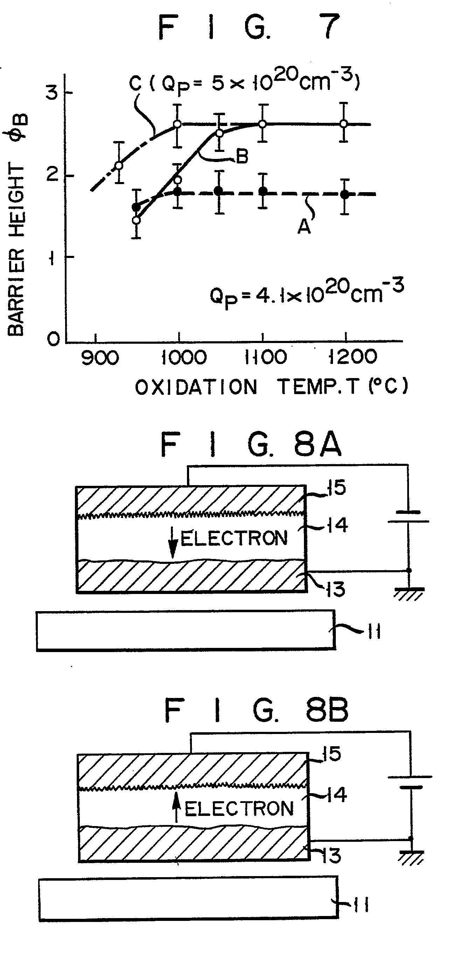

A determination method of the boundary indicated by characteristic curve a in Fig. 6 will be explained with reference to Fig. 7. Fig. 7 exemplifies the relationship between oxidation temperature T and effective barrier height $\phi$B when the phosphorus concentrations in the polysilicon film are $4.1 \times 10^{20}$ cm$^{-3}$ and $5 \times 10^{20}$ cm$^{-3}$.

Note that barrier height $\phi$B indicates the level of an effective energy barrier between the polysilicon film and the insulating film, i.e., difficulty of injection when electrons or charges are injected from one polysilicon film to the other polysilicon film through the insulating film, as shown in Figs. 8A and 8B. This also serves as a parameter indicating the level of electric field concentration on the polysilicon film surface, i.e., the flatness of the film surface.

Characteristic curve A in Fig. 7 indicates the difficulty of electron injection from second polysilicon film 15 having the roughened portion to first polysilicon film 13 through first thermal oxide film 14, as shown in Fig. 8A. Characteristic curve B indicates the difficulty of electron injection from first polysilicon film 13 to second polysilicon film 15 through thermal oxide film 14, as shown in Fig. 8B.

As can be seen from Fig. 7, in the state indicated by characteristic curve A, even if the oxidation temperature varied widely (in this case, within the range of 1,000 to 1,200°C), barrier height $\phi$B was stable.

From another test result, even if phosphorus concentration in the polysilicon film was changed, substantially uniform barrier height $\phi$B could be obtained.

In contrast to this, in the state indicated by characteristic curve B, when oxidation temperature T was below 1,100°C, barrier height $\phi$B was gradually decreased. However, when phosphorus concentration Qp was increased, as indicated by characteristic curve C, stable barrier height $\phi$B could be obtained at lower oxidation temperature T (in this case, about 1,000°C).

In order to improve the electron (or charge) write and erase characteristics of the above-mentioned semiconductor apparatus, a difference between characteristic curves A and B respectively corresponding to the write and erase operations shown in Fig. 7 is preferably increased and, more preferably, difference $\Delta\phi$B exceeds 0.5 eV.

Note that oxidation temperature T exceeding 1,300°C is undesirable since high-precision control is difficult. When phosphorus concentration Qp is set below $1 \times 10^{20}$ cm$^{-3}$, the surface flattening phenomenon is interferred therewith, as shown in Fig. 6. When phosphorus concentration Qp exceeds $7 \times 10^{20}$ cm$^{-3}$, a large amount of phosphorus enters the insulating film, thus degrading the film quality and changing its characteristics.

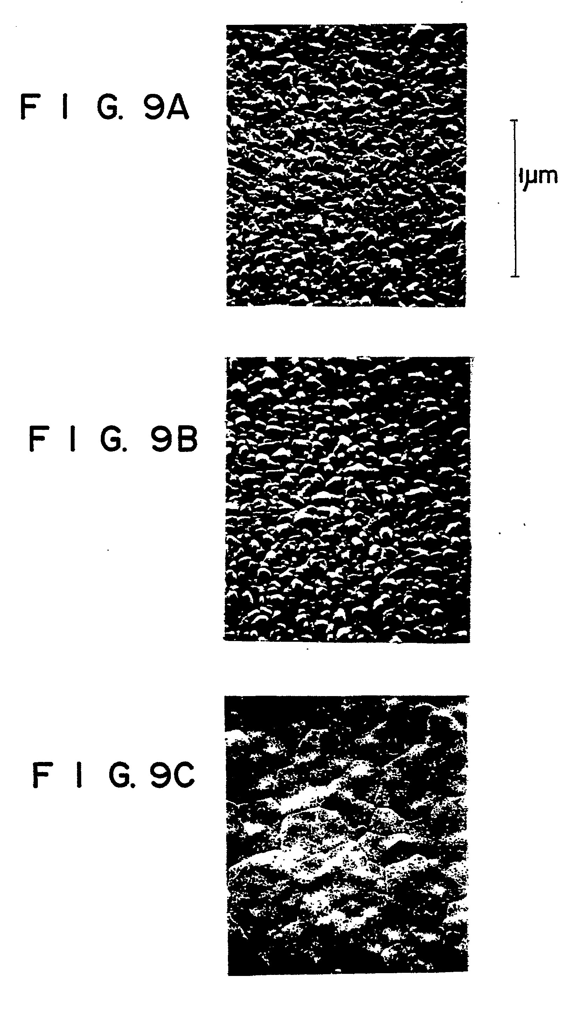

Figs. 9A to 9C are photographs showing the surface conditions of first polysilicon film 13. Fig. 9A shows the surface condition of film 13 immediately after polysilicon deposition. Fig. 9B shows the surface condition of thermal oxide film 14 after film 14 is formed on the surface of film 13. In Fig. 9B, the roughened shape of film 13 shown in Fig. 9A is duplicated by the surface of film 14. Fig. 9C shows the surface condition of film 13 after film 14 is formed. After film 14 is formed, the surface of film 13 is flattened.

More specifically, the surface shape of film 13 immediately after polysilicon deposition and that of film 14 represent substantially the same roughened shape (particle shape). In contrast to this, the surface of film 13 after film 14 is formed has an increased crystal particle size and is thereby sufficiently flattened.

Next, as shown in Fig. 5C, second polysilicon film 15 is selectively formed on oxide films 121 and 12 and on a portion of first thermal oxide film 14. The resultant structure is then oxidized to form second thermal oxide film 16 on film 15. As shown in Fig. 5D, third polysilicon film 17 is then selectively formed on field oxide film 12 and on a portion of second thermal oxide film 16. Thereafter, insulating film 18 of, e.g., CVD-SiO$_2$ is formed on the entire surface of the substrate as the insulating protective film.

Note that in the above descriptions, the source and drain regions of a MOS transistor, metal wiring layers, electrode contact portions, and the like are omitted for the sake of simplicity.

In the above embodiment, phosphorus is doped in polysilicon. However, an impurity doped in polysilicon is not limited to phosphorus, but can be arsenic. During polysilicon deposition, phosphorus is doped in the polysilicon film under the flow of phosphine (PH$_3$) gas. Alternatively, after a non-doped polysilicon film with a given roughened surface is deposited, an impurity (e.g., phosphorus) can be doped in the polysilicon film by ion-implantation.

In the above embodiment, charge injection and erase gates are formed of polysilicon. However, they can comprise amorphous materials (e.g., silicides, high-melting point metals, and the like).

As set out above, first and second polysilicon films 13 and 15 and are deposited by the low-pressure CVD method in a temperature atmosphere of 550° to 650°C.

That is, the deposited polysilicon is crystallized with this surface roughened. However, the means for forming the rough-surfaced polysilicon film is not restricted to the aforementioned polysilicon film depositing means using such a temperature atmosphere. The polysilicon film may also be deposited by the following method.

That is, an amorphous silicon film (a film in the amorphous state) is formed, while flowing a phosphine in a lower-temperature atmosphere of about 530° to 560°C, to obtain a phosphorus concentration of about "$4 \times 10^{20}$" in which case a smooth silicon film surface is obtained. This smooth-surfaced polysilicon film is plasma-etched in a $CF_4$ gas dominant atmosphere for a brief period of time to the extent of, for example, several to several tens of nanometer to obtain a rough-surfaced polysilicon film. Thereafter, the thermal oxidation step may be performed in the same way as mentioned above to obtain first and second rough-surfaced thermal oxide films 14 and 15.

Where such polysilicon film is to be formed by the low-pressure CVD method, an amorphous polysilicon is deposited in the temperature atmosphere of 530° to 560°C to obtain a smooth surface. In an atmosphere ranging from that temperature to below about 650°C a greater number of roughened portions are formed on the resultant surface of a deposited polysilicon film due to the crystallization of silicon. In an atmosphere of above 650°C, polysilicon crystals thus deposited have a large diameter, and the layer of polysilicon has a gently curving surface

## Claims

1. A method of manufacuring a nonvolatile semiconductor memory apparatus, in which a write and erase gate and a floating gate are stacked on a semiconductor substrate through insulating flims, and which is capable of writing and erasing data, characterized by comprising the steps of:
forming a first polysilicon film (13) constituting an erase gate on the surface of said semiconductor substrate (3, 2) at a temperature within the range of 550 to 650°C so that the surface of said first polysilicon film is roughened;
thermally treating said first polysilicon film formed in the previous step in an oxidation atmosphere at a temperature of 900 to 1,300°C to form a first thermal oxide film (14) on the surface of said first polysilicon film;
forming a second polysilicon film (15) constituting a floating gate, the surface of which is roughened, on at least a portion of said first thermal oxide film;
thermally treating said second polysilicon film to form a second thermal oxide film (16) thereon; and, forming a third polysilicon film (17) constituting a write gate on said second thermal oxide film.

2. A method according to claim 1, characterized in that said first to third polysilicon films (13, 15, 17) comprise polysilicon containing an impurity, and an impurity concentration thereof falls within the range of $1 \times 10^{20}$ to $7 \times 10^{20}$ cm$^{-3}$.

3. A method according to claim 2, characterized in that the impurity concentration of said first to third polysilicon films (13, 15, 17) preferably falls within the range of $3 \times 10^{20}$ to $6 \times 10^{20}$ cm$^{-3}$.

4. A method according to any of claims 1 to 3, characterized in that the impurity contained in the polysilicon constituting said first to third polysilicon films (13, 15, 17) is phosphorus.

5. A method according to any of claims 1 to 3, characterized in that the impurity contained in the polysilicon constituting said first to third polysilicon films (13, 15, 17) is arsenic.

6. A method according to any of claims 1, to 5, characterized in that the steps of forming said first to third polysilicon films (13, 15, 17) are achieved by means for growing polysilicon on said thermal oxide films respectively in a low-temperature atmosphere.

7. A method according to claims 1 to 6, characterized in that said first to third polysilicon films (13, 15, 17) are formed by a low-pressure CVD method.

8. A method according to claim 1, characterized in that the step of forming said second thermal oxide film (16) is a step of thermally oxidizing the surface of said second polysilicon film (13, 15) at a temperature of 900 to 1,300°C.

9. A method according to claim 8, characterized in that the thermal oxidation temperature preferably falls within the range of 1,000 to 1,200°C.

10. A method according to any of claims 1 to 9, characterized in that said first and/or second thermal oxide films (14, 16) are formed by oxidation in a dry oxygen atmosphere.

11. A method according to any of claims 1 to 10, characterized in that said first and/or second thermal oxide films (14, 16) are formed by oxidation in an atmosphere of a dry oxygen gas containing chlorine.

## Revendications

1. Procédé de fabrication d'un dispositif à mémoire rémanente à semi-conducteur, dans lequel une porte d'écriture ou d'effacement et une porte flottante sont empilées sur un substrat semi-conducteur par l'intermédiaire de pellicules isolantes, et qui est capable d'écrire et d'effacer des données, caractérisé en ce qu'il comprend les étapes consistant à:
– former une première pellicule de polysilicium (13) constituant une porte d'effacement sur la surface du substrat semi-conducteur (11) à une température comprise dans la gamme de 550 à 650°C de façon que la surface de la première pellicule de polysilicium soit rugueuse;
– traiter thermiquement la première pellicule de polysilicium formée dans l'étape précédente dans une atmosphère oxydante à une température de 900 à 1300°C afin de former une première pellicule d'oxyde thermique (14) sur la surface de la première pellicule de polysilicium;
– former une seconde pellicule de polysilicium (15) constituant une porte flottante, dont la surface est rugueuse, sur au moins une partie de la première pellicule d'oxyde thermique;
– traiter thermiquement la seconde pellicule de polysilicium de manière à former une seconde pellicule d'oxyde thermique (16) sur son dessus; et

– former une troisième pellicule de polysilicium (17) constituant une porte d'écriture sur la seconde pellicule d'oxyde thermique.

2. Procédé selon la revendication 1, caractérisé en ce que les première à troisième pellicules de polysilicium (13, 15, 17) comprennent du polysilicium contenant une impureté, et la concentration en impuretés tombe dans la plage allant de $1 \times 10^{20}$ à $7 \times 10^{20}$ cm$^{-3}$.

3. Procédé selon la revendication 2, caractérisé en ce que la concentration en impuretés des première et troisième pellicules de polysilicium (13, 15, 17) tombe de préférence dans la plage allant de $3 \times 10^{20}$ à $6 \times 10^{20}$ cm$^{-3}$.

4. Procédé selon l'une quelconque des revendications 1 à 3, caractérisé en ce que l'impureté contenue dans le polysilicium constituant les première à troisième pellicules de polysilicium (13, 15, 17) est le phosphore.

5. Procédé selon l'une quelconque des revendications 1 à 3, caractérisé en ce que l'impureté contenue dans le polysilicium constituant les première à troisième pellicules de polysilicium (13, 15, 17) est l'arsenic.

6. Procédé selon l'une quelconque des revendications 1 à 5, caractérisé en ce que les étapes de formation des première à troisième pellicules de polysilicium (13, 15, 17) sont obtenues par croissance de polysilicium sur les pellicules d'oxyde thermique, respectivement, dans une atmosphère à basse température.

7. Procédé selon les revendications 1 à 6, caractérisé en ce que les première à troisième pellicules de polysilicium (13, 15, 17) sont formées par un procédé de déposition en phase gazeuse par procédé chimique à basse pression.

8. Procédé selon la revendication 1, caractérisé en ce que l'étape consistant à former la seconde pellicule d'oxyde thermique (16) est une étape consistant à oxyder thermiquement la surface de la seconde pellicule de polysilicium (15) à une température de 900 à 1300°C.

9. Procédé selon la revendication 8, caractérisé en ce que la température d'oxydation thermique tombe de préférence dans la gamme de 1000 à 1200°C.

10. Procédé selon l'une quelconque des revendications 1 à 9, caractérisé en ce que la première et/ou la seconde pellicule d'oxyde thermique (14, 16) sont formées par oxydation dans une atmosphère sèche d'oxygène.

11. Procédé selon l'une quelconque des revendications 1 à 10, caractérisé en ce que la première et/ou la seconde pellicule d'oxyde thermique (14, 16) sont formées par oxydation dans une atmosphère d'oxygène gazeux sec contenant du chlore.

## Patentansprüche

1. Ein Verfahren zur Herstellung einer nichtflüchtigen Halbleiterspeichervorrichtung, in welcher ein Schreib- oder Löschgate und ein floatendes Gate auf einem Halbleitersubstrat durch Isolierfilme geschichtet sind und welche Daten schreiben und löschen kann, dadurch gekennzeichnet, daß folgende Schritte umfaßt werden:

Bilden eines ersten Polysiliciumfilmes (13), welcher ein Löschgate auf der Oberfläche des besagten Halbleitersubstrates (11) bei einer Temperatur innerhalb des Bereiches von 550 bis 650°C bildet, so daß die Oberfläche besagten ersten Polysiliciumfilmes aufgerauht ist;

Wärmebehandeln des besagten ersten Polysiliciumfilmes, der in dem vorigen Schritt in einer Oxidationsatmosphäre bei einer Temperatur von 900 bis 1300°C gebildet wurde, um einen ersten thermischen Oxidfilm (14) auf der Oberfläche von besagtem ersten Polysiliciumfilm zu bilden;

Bilden eines zweiten Polysiliciumfilmes (15), der ein floatendes Gate, dessen Oberfläche aufgerauht ist, auf wenigstens einem Teil von besagtem ersten thermischen Oxidfilm bildet;

Wärmebehandeln besagten zweiten Polysiliciumfilmes, um einen zweiten thermischen Oxidfilm (16) darauf zu bilden; und

Bilden eines dritten Polysiliciumfilmes (17), der ein Schreibgate auf besagtem zweiten thermischen Oxidfilm bildet.

2. Ein Verfahren nach Anspruch 1, dadurch gekennzeichnet, daß besagte erste bis dritte Polysiliciumfilme (13, 15, 17) Polysilicium umfassen, welches eine Verunreinigung enthält und dessen Verunreinigungskonzentration in den Bereich von $1 \times 10^{20}$ bis $7 \times 10^{20}$ cm$^{-3}$ fällt.

3. Ein Verfahren nach Anspruch 2, dadurch gekennzeichnet, daß die Verunreinigungskonzentration besagter erster bis dritter Polysiliciumfilme (13, 15, 17) vorzugsweise in den Bereich von $3 \times 10^{20}$ bis $6 \times 10^{20}$ cm$^{-3}$ fallen.

4. Ein Verfahren nach irgendeinem der Ansprüche 1 bis 3, dadurch gekennzeichnet, daß die Verunreinigung, die in dem Polysilicium enthalten ist, welches besagte erste bis dritte Polysiliciumfilme (13, 15, 17) bildet, Phosphor ist.

5. Ein Verfahren nach irgendeinem der Ansprüche 1 bis 3, dadurch gekennzeichnet, daß die Verunreinigung, die in dem Polysilicium enthalten ist, welches besagte erste bis dritte Polysiliciumfilme (13, 15, 17) bildet, Arsen ist.

6. Ein Verfahren nach irgendeinem der Ansprüche 1 bis 5, dadurch gekennzeichnet, daß die Bildungsschritte besagter erster bis dritter Polysiliciumfilme (13, 15, 17) erhalten werden durch Mittel zum Wachsen von Polysilicium auf den jeweiligen thermischen Oxidfilmen in einer Atmosphäre mit Niedrigtemperatur.

7. Ein Verfahren nach den Ansprüchen 1 bis 6, dadurch gekennzeichnet, daß besagte erste bis dritte Polysiliciumfilme (13, 15, 17) durch ein Niederdruck-CVD-Verfahren gebildet werden.

8. Ein Verfahren nach Anspruch 1, dadurch gekennzeichnet, daß der Bildungsschritt von besagtem zweiten thermischen Oxidfilm (16) ein Schritt des thermischen Oxidierens der Oberfläche besagten zweiten Polysiliciumfilmes (13, 15) bei einer Temperatur von 900 bis 1 300°C, ist.

9. Ein Verfahren nach Anspruch 8, dadurch gekennzeichnet, daß die thermische Oxidationstemperatur vorzugsweise in den Bereich von 1000 bis 1200°C fällt.

10. Ein Verfahren nach irgendeinem der Ansprüche 1 bis 9, dadurch gekennzeichnet, daß besagte erste und/oder zweite thermische Oxidfilme (14, 16) durch Oxidation in einer Atmosphäre mit trockenem Sauerstoff gebildet werden.

11. Ein Verfahren nach irgendeinem der Ansprüche 1 bis 10, dadurch gekennzeichnet, daß besagte erste und/oder zweite thermische Oxidfilme (14, 16) durch Oxidation in einer Atmosphäre von trockenem Sauerstoffgas, welches Chlor enthält, gebildet werden.

F I G. 1

F I G. 2

F I G. 3

# F I G. 4

$V_3(5V)$

17  18  16

15

14

13

12

$N^+$  11

$P^-$

19(20)

$V_1$

$V_2(10V)$

# F I G. 5A

13

12

$P^-$  11

# F I G. 5B

14

121  13

12

11

# F I G. 5C

# F I G. 5D

# F I G. 6

$(\times 10^{20} cm^{-3})$

PHOSPHORUS CONCENTRATION $Q_P$

OXIDATION TEMP. $(^{\circ}C)$ T

F I G. 7

F I G. 8A

F I G. 8B

F I G. 9A

1μm

F I G. 9B

F I G. 9C